# EUROPÄISCHE PATENTSCHRIFT

(11) **EP 3 054 023 B1**
(45) Veröffentlichungstag und Bekanntmachung des Hinweises auf die Patenterteilung: **28.08.2019**
(21) Anmeldenummer: 14176860.6
(22) Anmeldetag: 14.07.2014
(51) Int. Cl.: C22C 14/00, C22C 1/02, C22C 1/04, C22C 21/00

(54) **AL-REICHE HOCHTEMPERATUR-TIAL -LEGIERUNG**
ALUMINIUM-RICH HIGH TEMPERATURE TIAL ALLOY
HAUTE TEMPÉRATURE ALLIAGE DE TI-AL RICHE EN ALUMINIUM

(43) Veröffentlichungstag der Anmeldung: 10.08.2016
(60) Teilanmeldung: 19170384.2
(73) Patentinhaber: MTU Aero Engines AG, 80995 München (DE)
(72) Erfinder: Smarsly, Wilfried, 81669 München (DE); Schloffer, Martin, 81247 München (DE); Clemens, Helmut, 8700 Leoben (AT); Mayer, Svea, 8784 Trieben (AT)
(74) Vertreter: Lang, Christian

(56) Entgegenhaltungen:
- EP-A1- 0 592 189
- JP-A- H02 163 333
- JP-A- H02 258 938
- JP-A- H03 285 051
- US-A- 5 284 620
- US-A- 5 348 594
- Massalski: "Binary Alloy Phase Diagrams", 1. Januar 1987 (1987-01-01), ASM International, XP002734120, Bd. 1, Seiten 226-226, * das ganze Dokument *
- M. Yoshihara ET AL: "Effects of Nb addition on oxidation behavior of TiAl", INTERMETALLICS., vol. 3, no. 5, 1 January 1995 (1995-01-01) , pages 357-363, XP055543787, GB ISSN: 0966-9795, DOI: 10.1016/0966-9795(95)94254-C

## Beschreibung

### HINTERGRUND DER ERFINDUNG

### GEBIET DER DER ERFINDUNG

Die folgende Erfindung betrifft eine TiAl - Legierung für den Einsatz bei hohen Temperaturen, insbesondere im Bereich von 750°C bis 950°C, sowie ihre Herstellung und ihre Verwendung.

### STAND DER TECHNIK

Legierungen auf Basis von intermetallischen Titanaluminid - Verbindungen finden beim Bau von stationären Gasturbinen oder Flugtriebwerken, beispielsweise als Werkstoff für Laufschaufeln, Verwendung, da sie die für den Einsatz erforderlichen mechanischen Eigenschaften aufweisen und zusätzlich ein geringes spezifisches Gewicht besitzen, sodass der Einsatz derartiger Legierungen die Effizienz von stationären Gasturbinen und Flugtriebwerken steigern kann.

Entsprechend wurde bereits eine Vielzahl von TiAl - Legierungen entwickelt, wobei derzeit insbesondere TiAl - Legierungen auf Basis der intermetallischen γ - TiAl - Phase eingesetzt werden, die mit Niob und Molybdän oder Bor legiert sind und deshalb als TNM bzw. TNB - Legierungen bezeichnet werden. Derartige Legierungen weisen als Hauptbestandteil Titan sowie ca. 40 bis 45 at.% Aluminium, um 5 at.% Niob und beispielsweise 1 at.% Molybdän sowie geringe Anteile an Bor auf. Das Gefüge ist durch einen hohen γ - TiAl - Anteil und ebenfalls deutliche Anteile an α₂ - Ti₃Al gekennzeichnet, wobei weitere Phasen, wie z.B. β - Phase oder B19 - Phase, in geringerem Anteil vorkommen können.

Die bekannten TNM - oder TNB - Legierungen auf γ - TiAl - Basis weisen üblicherweise ein globulares, gleichachsiges γ - TiAl - Gefüge, ein lamellares Gefüge oder ein Duplex - Gefüge mit globularen, gleichachsigen γ - TiAl - Körnern und lamellaren Bereichen aus γ - TiAl und α₂ - Ti₃Al auf. Obwohl derartige γ - TiAl - Legierungen insbesondere mit lamellaren Mikrostrukturen insgesamt sehr gute mechanische Eigenschaften bis 750°C aufweisen, kommt es bei höheren Temperaturen auf Grund der thermodynamischen Instabilität des Gefüges zu einer Verschlechterung der mechanischen Eigenschaften, wobei insbesondere die Kriechbeständigkeit abnimmt. Bei Temperaturen von über 700°C kommt es zusätzlich zur Eindiffusion von Sauerstoff in die Bauteilrandzone mit der Folge von Phaseninstabilitäten, mikrostrukturellen Veränderungen und der Versprödung des Werkstoffs.

Das Dokument EP 0 592 189 A1 offenbart eine TiAl - Legierung mit hoher Hochtemperaturfestigkeit, bei der in einem Gefüge aus γ - TiAl ein Anteil einer fein dispers verteilten β - Phase eingelagert ist.

Das Dokument US 5 284 620 A offenbart eine TiAl - Legierung, in der Boride eingelagert sind, um einen Werkstoff mit erhöhter Festigkeit zu bilden.

### OFFENBARUNG DER ERFINDUNG

### AUFGABE DER ERFINDUNG

Es ist deshalb Aufgabe der vorliegenden Erfindung eine Legierung bereitzustellen, welche ein niedriges spezifisches Gewicht ähnlich den bekannten γ - TiAl - Legierungen sowie vergleichbare mechanische Eigenschaften, insbesondere bei hohen Temperaturen, aufweist, wobei der Einsatzbereich vorzugsweise auf Temperaturen im Bereich von 750° bis 900°C oder 950°C ausgeweitet ist. Eine derartige Legierung soll im industriellen Maßstab ohne übermäßigen Aufwand herstellbar und verarbeitbar sein sowie in stationären Gasturbinen und Flugzeugtriebwerken zuverlässig eingesetzt werden können.

### TECHNISCHE LÖSUNG

Diese Aufgabe wird gelöst durch eine TiAl - Legierung mit den Merkmalen des Anspruchs 1, einem Verfahren zur Herstellung einer TiAl - Legierung mit den Merkmalen des Anspruchs 7 sowie der Verwendung der TiAl - Legierung mit den Merkmalen des Anspruchs 10. Weitere vorteilhafte Ausgestaltungen sind Gegenstand der abhängigen Ansprüche.

Unter TiAl - Legierung wird im Folgenden eine Legierung verstanden, deren Hauptbestandteile Titan und Aluminium sind, sodass also der Anteil an Aluminium und Titan in at.% oder Gew.% jeweils größer ist als der entsprechende Anteil jeder anderen Legierungskomponente. Hierbei kann der Aluminium - Anteil in at.% oder Gew.% größer als der Titan - Anteil sein, auch wenn die Bezeichnung TiAl das Gegenteil anzudeuten scheint. Darüber hinaus wird unter einer erfindungsgemäßen TiAl - Legierung eine Legierung verstanden, die überwiegend aus intermetallischen Phasen mit den Bestandteilen Titan und/oder Aluminium aufgebaut ist. Unter intermetallischen Phasen sind Phasen des TiAl -Systems zu verstehen, die einen hohen Anteil kovalenter Bindungskräfte innerhalb der metallischen Bindung aufweisen und so über eine hohe Festigkeit und insbesondere auch Hochtemperaturfestigkeit verfügen.

Gemäß der Erfindung wird eine TiAl - Legierung vorgeschlagen, die einen Aluminiumanteil von 50 at.% oder mehr aufweist und mit einer γ - TiAl - Matrix ausgebildet ist. Zusätzlich weist das Gefüge der erfindungsgemäßen TiAl - Legierung in der Matrix eingelagerte Phasen aus Aluminium und Titan auf, die unterschiedlich zur γ - TiAl - Phase sind, sowie Ausscheidungen aus Oxiden und/oder Karbiden.

Durch das erfindungsgemäße Gefüge können die erforderlichen Eigenschaften der TiAl - Legierung hinsichtlich Duktilität, Festigkeit, insbesondere Hochtemperaturfestigkeit, Bruchzähigkeit und Kriech - sowie Oxidationsbeständigkeit bis zu Einsatztemperaturen von bis zu 950°C erreicht werden, wobei die in der γ - TiAl - Matrix eingelagerten Ausscheidungen in Form von weiteren Titan und Aluminium enthaltenden Phasen sowie Oxiden und/oder Karbiden die erforderliche Festigkeit verleihen.

Der Aluminiumanteil einer derartigen Legierung kann bis zu 75 at.%, vorzugsweise bis zu 65 at.%, insbesondere bis zu 60 at.% betragen, sodass sich insbesondere aluminiumreiche, intermetallische Phasen, wie Al₃Ti und Al₂Ti bilden können, die bei den hohen Temperaturen beständig und insbesondere auch gegenüber Oxidationsangriffen unempfindlich sind.

Die TiAl - Legierung kann insbesondere so eingestellt werden, dass die γ - TiAl - Matrix 50 vol.% oder mehr des Gefüges einnimmt und sich insbesondere eine geschlossene, globulare bzw. eine netzartige γ - TiAl - Matrix bildet, sodass ein durchgängig duktiles Gefüge vorliegt. Unter geschlossener oder netzartiger Matrix wird eine Form der γ - TiAl - Matrix verstanden, bei der keine oder nahezu keine isolierten γ - TiAl - Bereiche vorliegen, die vollständig von anderen Phasen umgeben sind und somit keine Verbindung zu benachbarten Bereichen der γ - TiAl - Phase aufweisen würden.

Neben den bereits oben erwähnten aluminiumreichen, intermetallischen Phasen, wie insbesondere Al₃Ti und Al₂Ti, kann das Gefüge weitere Phasen enthalten, die im Wesentlichen aus Aluminium und Titan gebildet sind, also überwiegend diese Legierungsbestandteile enthalten, wie beispielsweise β - Titan und Morphologien der β - Phase wie die β₀ - Phase.

Die intermetallischen Phasen, die in der γ - TiAl - Matrix vorliegen, können als lamellare Ausscheidungen, als plattenförmige Ausscheidungen oder als globulare Ausscheidungen vorliegen und können sowohl dafür sorgen, dass die Komgrenzen stabilisiert werden und/oder dass bei feiner Ausbildung der Ausscheidungen auch die Versetzungsbewegung behindert wird. Die Stabilisierung der Komgrenzen kann eine Verringerung bzw. Behinderung des Kornwachstums bei hohen Temperaturen bewirken.

Die Oxid - und / oder Karbid - Ausscheidungen können durch verschiedene, nachfolgend noch beschriebene Legierungsbestandteile gebildet werden.

Unter anderem können Zirkonoxid und Yttriumoxid feindispers in der Matrix eingelagert sein, um Versetzungen bei hohen Temperaturen an der Bewegung zu hindern. Die Oxide können eine mittlere oder maximale Partikelgröße von 1µm oder kleiner, insbesondere Partikelgrößen im Nanometerbereich, aufweisen, sodass sich eine sehr feine Verteilung der Oxide im Gefüge ergibt.

Die in der γ - TiAl - Matrix eingelagerten Oxide können durch mechanisches Legieren in die Legierung eingebracht werden, wobei unmittelbar entsprechende Oxide zulegiert werden können. Darüber hinaus ist es auch möglich, Oxidbildner, wie Yttrium oder Zirkon, fein verteilt in metallischer Form zuzulegieren, sodass bei Wärmebehandlungen im Herstellungsprozess der Legierung bzw. eines daraus gebildeten Bauteils vorhandener Sauerstoff mit den Oxidbildnern reagieren kann, um die fein dispers verteilten Oxide in der Matrix auszubilden. Hierbei ist es auch denkbar, dass die Ausscheidungen erst im Betrieb bei entsprechend hohen Einsatztemperaturen gebildet werden.

Weitere Ausscheidungen, die in der Matrix eingelagert sein können, sind Karbide, wie beispielsweise Wolframkarbid, Chromkarbid oder Zirkonkarbid, wobei bei hohen Temperaturen stabile Karbide wiederum die Komgrenzen stabilisieren und das Kornwachstum verhindern bzw. verringern können.

Die Legierung kann ein oder mehrere Bestandteile aus der Gruppe umfassen, die Niob, Molybdän, Wolfram, Kobalt, Chrom, Vanadium, Zirkon, Silizium, Kohlenstoff, Erbium, Gadolinium, Hafnium, Yttrium und Bor beinhaltet.

Die Zugabe von Silizium, Erbium und / oder Gadolinium kann die Sauerstoffdiffusion in den Werkstoff hemmen, sodass die bei derzeitigen TiAl - Legierungen zu beobachtende Eindiffusion von Sauerstoff bei Temperaturen von über 700° Celsius verringert bzw. vermieden werden kann, sodass unabhängig und im Zusammenspiel mit den gegenüber Sauerstoffangriff unempfindlichen, aluminiumreichen Phasen die Gefügedestabilisierung durch Sauerstoffangriff in den Bauteilrandzonen verringert bzw. verhindert werden kann.

Die Legierungsbestandteile können mit folgenden Anteilen in der Legierung enthalten sein, um das oben beschriebene, vorteilhafte Gefüge einstellen zu können:

| | | |
|---|---|---|
| W | 0 bis 3 at.% | |
| Si | 0,2 bis 0,35 at.% | |
| C | 0 bis 0,6 at. % | |
| Zr | 0 bis 6 at.% | |
| Y | 0 bis 0,5 at.% | |
| Hf | 0 bis 0,3 at.% | |
| Er | 0 bis 0,5 at.% | |
| Gd | 0 bis 0,5 at.% | |
| B | 0 bis 0,2 at.% | und |
| Nb | 4 bis 25 at.% | und |
| Mo | 1 bis 10 at.% | und/oder |
| W | 0,5 bis 3,0 at.% | und/oder |
| Co | 0,1 bis 10 at.% | und/oder |
| Cr | 0,5 bis 3,0 at.% | und/oder |
| V | 0,5 bis 10 at.% . | |

Die γ - TiAl - Legierung der vorliegenden Erfindung kann schmelzmetallurgisch oder pulvermetallurgisch hergestellt werden und es können auch die beiden Herstellrouten miteinander kombiniert werden, indem beispielsweise zumindest ein Teil des für die pulvermetallurgische Herstellung benötigten Materials schmelzmetallurgisch hergestellt wird, um dann mit Pulver von anderen Bestandteilen pulvermetallurgisch weiter verarbeitet zu werden. Insbesondere können zumindest Teile der Legierungsbestandteile mechanisch legiert werden, um beispielsweise die feine Verteilung der Oxide (Oxid - Dispersionsverfestigung) zu ermöglichen.

Insbesondere kann die Legierung durch Lichtbogenschmelzen unter Vakuum oder Schutzgasatmosphäre erschmolzen werden.

Die abgegossene Legierung kann durch heißisostatisches Pressen verdichtet werden, um beispielsweise bei der Erstarrung erstandene Poren zu beseitigen. Ein heißisostatisches Pressen kann auch bei pulvermetallurgischer Herstellung durchgeführt werden.

Eine entsprechende Legierung kann bereits endkonturnah gegossen oder mittels der pulvermetallurgischen Herstellung endkontumah zu einem zu fertigendem Bauteil gefertigt werden oder die Legierung kann nach dem Gießen durch Schmieden, insbesondere isothermes Schmiedes umgeformt werden.

Die Legierung oder ein aus der Legierung hergestelltes Bauteil können einer ein - oder mehrstufigen Wärmebehandlung unterzogen werden, um das entsprechende Gefüge mit den Ausscheidungen einzustellen.

Die TiAl - Legierung kann insbesondere für Bauteile von Strömungsmaschinen Verwendung finden, wie beispielsweise für Komponenten eines Flugtriebwerks, bei denen die Betriebstemperaturen bis zu 950° Celsius betragen können.

### KURZBESCHREIBUNG DER FIGUR

Die beigefügte Figur zeigt in rein schematischer Weise ein Ausführungsbeispiel eines Gefüges einer erfindungsgemäßen TiAl - Legierung.

### AUSFÜHRUNGSBEISPIEL

Weitere Vorteile, Kennzeichen und Merkmale der vorliegenden Erfindung werden bei der nachfolgenden detaillierten Beschreibung eines Ausführungsbeispiels deutlich, wobei die Erfindung jedoch nicht auf dieses Ausführungsbeispiel beschränkt ist.

Die Figur zeigt ein Gefüge einer erfindungsgemäßen TiAl - Legierung in einer rein schematischen Darstellung.

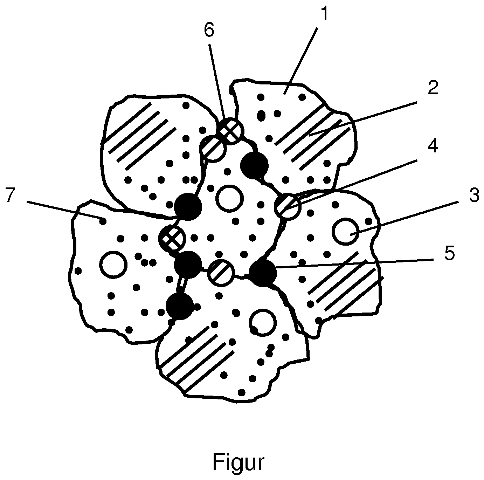

Die Fig. 1 zeigt in einer Schnittansicht globulare γ - TiAl - Körner 1, die die γ - TiAl - Matrix bilden. An den Komgrenzen sind teilweise Karbide 4 und Silizide 5 sowie Oxide 6 ausgeschieden, die die Korngrenzen stabilisieren. Innerhalb der γ - TiAl - Körner sind Ausscheidungen von intermetallischen Phasen, wie Al₃Ti und Al₂Ti zu sehen, die als globulare Ausscheidungen 3 oder als lamellare Ausscheidungen 2 in den γ - TiAl - Körnern bzw. zwischen den γ - TiAl - Körnern 1 ausgebildet sind.

In den γ - TiAl - Körnern sind weiterhin fein dispers verteilte Oxidpartikel 7, beispielsweise in Form von Yttriumoxid oder Zirkonoxid, mit einer mittleren oder maximalen Partikelgröße im Bereich kleiner oder gleich 1 µm, vorzugsweise im Nanometerbereich, eingelagert.

Ein derartiger Werkstoff bietet insbesondere für mechanisch hoch beanspruchte Bauteile bei hohen Temperaturen, wie beispielsweise Komponenten von Gasturbinen oder Flugtriebwerken ein ausgewogenes Eigenschaftsprofil mit niedrigem spezifischem Gewicht, hoher mechanischer Festigkeit, ausreichender Duktilität sowie gutem Hochtemperaturverhalten mit hoher Kriechbeständigkeit und guter Oxidationsbeständigkeit.

Obwohl die vorliegende Erfindung anhand des Ausführungsbeispiels detailliert beschrieben worden ist, ist die Erfindung nicht auf dieses Ausführungsbeispiel beschränkt, sondern es gibt vielmehr Abwandlungen in der Weise, dass einzelne Merkmale weggelassen oder andersartige Kombinationen von Merkmalen verwirklicht werden können, solange der Schutzbereich der beigefügten Ansprüche nicht verlassen wird.

### BEZUGSZEICHENLISTE

- 1: γ - TiAl - Körner der γ - TiAl - Matrix
- 2: lamellare Ti - Al - Ausscheidungen
- 3: globulare Ti - Al - Ausscheidungen
- 4: Karbide
- 5: Silizide
- 6: Oxide
- 7: Oxide (fein dispers verteilt)

## Patentansprüche

1. TiAl - Legierung für den Einsatz bei hohen Temperaturen mit den Hauptbestandteilen Aluminium und Titan, wobei die TiAl - Legierung einen Aluminium - Anteil von größer oder gleich 50 at.% und eine Matrix aus γ - TiAl (1) und mindestens eine in der γ - TiAl - Matrix eingelagerte, zu γ - TiAl unterschiedliche Phase (2,3) aus Al und Ti sowie Ausscheidungen aus Oxiden (6,7) und/oder Karbiden (4) aufweist, wobei die Legierung folgende Elemente mit den angegebenen Anteilen beinhaltet:
| | | |
|---|---|---|
| Nb | 4 bis 25 at.% | und |
| Mo | 1 bis 10 at.% | und/oder |
| W | 0,5 bis 3,0 at.% | und/oder |
| Co | 0,1 bis 10 at.% | und/oder |
| Cr | 0,5 bis 3,0 at.% | und/oder |
| V | 0,5 bis 10,0 at.% | und/oder |
| Si | 0,2 bis 0,35 at.% | |
| C | 0 bis 0,6 at. % | |
| Zr | 0 bis 6 at.% | |
| Y | 0 bis 0,5 at.% | |
| Hf | 0 bis 0,3 at.% | |
| Er | 0 bis 0,5 at.% | |
| Gd | 0 bis 0,5 at.% | |
| B | 0 bis 0,2 at.%. | |
sowie Rest Ti.

2. TiAl - Legierung nach Anspruch 1,
**dadurch gekennzeichnet, dass**
der Aluminium - Anteil bis zu 75 at.%, vorzugsweise bis zu 65 at.%, insbesondere bis zu 60 at.% beträgt.

3. TiAl - Legierung nach einem der vorhergehenden Ansprüche,
**dadurch gekennzeichnet, dass**
die γ - TiAl - Matrix 50 vol.%. oder mehr des Gefüges einnimmt.

4. TiAl - Legierung nach einem der vorhergehenden Ansprüche,
**dadurch gekennzeichnet, dass**
die γ - TiAl - Matrix (1) ein in sich geschlossenes, netzartiges oder globulares Gefüge aufweist.

5. TiAl - Legierung nach einem der vorhergehenden Ansprüche,
**dadurch gekennzeichnet, dass**
die zu γ - TiAl unterschiedlichen Phasen (2,3) aus Al und Tiβ - Phase und/oder Al - reiche intermetallische Phasen umfassen, insbesondere Al₃Ti und Al₂Ti.

6. TiAl - Legierung nach einem der vorhergehenden Ansprüche,
**dadurch gekennzeichnet, dass**
die Ausscheidungen ZrO₂ und/oder Y₂O₃ umfassen.

7. Verfahren zur Herstellung einer TiAl - Legierung nach einem der vorhergehenden Ansprüche oder einem aus dieser Legierung hergestelltem Bauteil, bei dem
die Legierung schmelzmetallurgisch hergestellt und einkristallin gezogen oder polykristallin abgegossen wird oder
bei dem die Legierung zumindest teilweise pulvermetallurgisch hergestellt wird und vorzugsweise zumindest Teile der Legierungsbestandteile mechanisch legiert werden.

8. Verfahren nach Anspruch 7,
**dadurch gekennzeichnet, dass**
die Legierung durch Lichtbogenschmelzen unter Vakuum oder Schutzgasatmosphäre erschmolzen wird und/oder durch Schleuderguss abgegossen wird.

9. Verfahren nach Anspruch 7 oder 8,
**dadurch gekennzeichnet, dass**
die Legierung nach dem Gießen oder der pulvermetallurgischen Herstellung heißisostatisch gepresst wird und/oder isotherm geschmiedet wird.

10. Verwendung einer TiAl - Legierung nach einem der Ansprüche 1 bis 6 zur Bildung einer Komponente für eine Strömungsmaschine, insbesondere für ein Flugtriebwerk.

## Claims

1. TiAl alloy for use at high temperatures, wherein the main constituents are aluminium and titanium, wherein the TiAl alloy has an aluminium content of greater than or equal to 50 at.% and comprises a matrix of γ-TiAl (1) and at least one phase (2, 3) of Al and Ti which is different from γ-TiAl and is incorporated in the γ-TiAl matrix, and precipitations of oxides (6, 7) and/or Carbides (4), the alloy containing the following elements in the stated percentages;
| | |
|---|---|
| Nb | 4 to 25 at.% and |
| Mo | 1 to 10 at.% and/or |
| W | 0.5 to 3.0 at.% and/or |
| Co | 0.1 to 10 at.% and/or |
| Cr | 0.5 to 3.0 at.% and/or |
| V | 0.5 to 10.0 at.% and/or |
| Si | 0.2 to 0.35 at.% |
| C | 0 to 0.6 at.% |
| Zr | 0 to 6 at.% |
| Y | 0 to 0.5 at.% |
| Hf | 0 to 0.3 at.% |
| Er | 0 to 0.5 at.% |
| Gd | 0 to 0.5 at.% |
| B | 0 to 0.2 at.%. |
and rest Ti.

2. TiAl alloy according to claim 1,
**characterised in that**
the aluminium content is up to 75 at.%, preferably up to 65 at.%, in particular up to 60 at.%.

3. TiAl alloy according to any of the preceding claims,
**characterised in that**
the γ-TiAl matrix occupies 50 vol.% or more of the microstructure.

4. TiAl alloy according to any of the preceding claims,
**characterised in that**
the γ-TiAl matrix (1) has a self-contained, reticular or globular structure.

5. TiAl alloy according to any of the preceding claims,
**characterised in that**
those phases (2, 3) of Al and Ti which are different from γ-TiAl comprise β-phase and/or Al-rich intermetallic phases, especially Al₃Ti and Al₂Ti.

6. TiAl alloy according to any of the preceding claims,
**characterised in that**
the precipitations comprise ZrO₂ and/or Y₂O₃.

7. Method for the production of a TiAl alloy according to any of the preceding claims or a component produced from this alloy, in which the alloy is produced by melt metallurgy and drawing it in monocrystalline form or casting it in polycrystalline form, or in which the alloy is produced at least partially by powder metallurgy and preferably at least parts of the alloy constituents are alloyed mechanically.

8. Method according to claim 7,
**characterised in that**
the alloy is melted by arc melting under vacuum or protective gas atmosphere and/or is cast by centrifugal casting.

9. Method according to claim 7 or 8,
**characterised in that**
the alloy is subjected to hot isostatic pressing and/or isothermal forging after it has been cast or produced by powder metallurgy.

10. Use of a TiAl alloy according to any of claims 1 to 6 to form a component for a turbomachine, especially for an aircraft engine.

## Revendications

1. Alliage TiAl destiné à être utilisé à des températures élevées avec comme constituants principaux l'aluminium et le titane, dans lequel l'alliage TiAl présente une proportion d'aluminium supérieure ou égale à 50 % at et une matrice γ-TiAl (1) et au moins une phase (2,3) d'Al et Ti noyée dans la matrice γ-TiAl et différente de γ-TiAl ainsi que des précipitations d'oxydes (6,7) et/ou de carbures (4), dans lequel l'alliage contient les éléments suivants avec les proportions indiquées:
| | | |
|---|---|---|
| Nb | 4 à 25 % at | et |
| Mo | 1 à 10 % at | et/ou |
| W | 0,5 à 3,0 % at | et/ou |
| Co | 0,1 à 10 % at | et/ou |
| Cr | 0,5 à 3,0 % at | et/ou |
| V | 0,5 à 10,0 % at | et/ou |
| Si | 0,2 à 0,35 % at | |
| C | 0 à 0,6 % at | |
| Zr | 0 à 6 % at | |
| Y | 0 à 0,5 % at | |
| Hf | 0 à 0,3 % at | |
| Er | 0 à 0,5 % at | |
| Gd | 0 à 0,5 % at | |
| B | 0 à 0,2 % at | |
ainsi que Ti pour le reste.

2. Alliage TiAl selon la revendication 1,
**caractérisé en ce que**
la proportion d'aluminium vaut jusqu'à 75 % at, de préférence jusqu'à 65 % at, en particulier jusqu'à 60 % at.

3. Alliage TiAl selon l'une quelconque des revendications précédentes,
**caractérisé en ce que**
la matrice γ-TiAl prend 50 % en volume ou plus de la structure.

4. Alliage TiAl selon l'une quelconque des revendications précédentes,
**caractérisé en ce que**
la matrice γ-TiAl (1) présente une structure fermée sur elle-même, réticulée ou globulaire.

5. Alliage TiAl selon l'une quelconque des revendications précédentes,
**caractérisé en ce que**
les phases (2,3) d'Al et Ti différentes de γ-TiAl comprennent une phase β et/ou des phases intermétalliques riches en Al, en particulier Al₃Ti et Al₂Ti.

6. Alliage TiAl selon l'une quelconque des revendications précédentes,
**caractérisé en ce que**
les précipitations comprennent ZrO₂ et/ou Y₂O₃.

7. Procédé de fabrication d'un alliage TiAl selon l'une quelconque des revendications précédentes ou d'une pièce fabriquée en cet alliage,
selon lequel l'alliage est fabriqué avec un procédé de métallurgie par fusion et étiré sous forme monocristalline ou coulé sous forme polycristalline ou
selon lequel l'alliage est fabriqué au moins en partie avec un procédé de métallurgie des poudres et de préférence au moins des parties des constituants d'alliage sont alliées de façon mécanique.

8. Procédé selon la revendication 7,
**caractérisé en ce que**
l'alliage est fondu par fusion à l'arc électrique sous vide ou sous atmosphère protectrice et/ou est coulé par coulée par centrifugation.

9. Procédé selon la revendication 7 ou 8,
**caractérisé en ce que**
après la coulée ou la fabrication par métallurgie des poudres, l'alliage est soumis à une compression isostatique à température élevée et/ou à un forgeage isothermique à matrice chaude.

10. Utilisation d'un alliage TiAl selon l'une quelconque des revendications 1 à 6 pour former un composant destiné à une turbomachine, en particulier à un moteur d'avion.
